(19) **Europäisches Patentamt / European Patent Office / Office européen des brevets**

(11) **EP 2 495 541 A1**

(12) **EUROPEAN PATENT APPLICATION**
published in accordance with Art. 153(4) EPC

(43) Date of publication:
05.09.2012 Bulletin 2012/36

(51) Int Cl.:
*G01J 9/02* *(2006.01)*

(21) Application number: 10761617.9

(22) Date of filing: 29.03.2010

(86) International application number:
PCT/JP2010/055619

(87) International publication number:
WO 2010/116918 (14.10.2010 Gazette 2010/41)

(84) Designated Contracting States:
AT BE BG CH CY CZ DE DK EE ES FI FR GB GR
HR HU IE IS IT LI LT LU LV MC MK MT NL NO PL
PT RO SE SI SK SM TR

(30) Priority: 29.03.2009 JP 2009080744

(71) Applicant: National University Corporation
Nagaoka University
Nagaoka-shi, Niigata 940-2188 (JP)

(72) Inventor: SHIODA Tatsutoshi
Nagaoka -shi
Niigata 940-2188 (JP)

(74) Representative: Hengelhaupt, Jürgen
Gulde Hengelhaupt
Ziebig & Schneider
Wallstraße 58/59
DE-10179 Berlin (DE)

(54) **RELATIVE PHASE DETECTOR, RELATIVE PHASE DETECTING METHOD AND INFORMATION READING DEVICE**

(57)  It detects the relative phase of two measured signals using two reference signals.

The relative phase detector 1 comprises reference signal generator 11, beat signal processor 12 and detecting element 13.

As for reference signal generator 11, a frequency interval generates two reference signals which are the same as the frequency interval of the measured signal of two above.

The beat signal processor 12 generates two beat signals from the reference signal of two measured signals and two above, and generation does the multiplication signal of these two beat signals.

It removes constant decided by detection system from the DC component of the multiplication signal, and detecting element 13 detects the relative phase of two measured signals.

FIG. 1

**Description**

FIELD OF THE INVENTION

The present invention relates to a relative phase detector, relative phase detecting method and an information reading device which the said relative phase detector was applied.

BACKGROUND ART

An optical heterodyne technology is known conventionally in the field of optical communication. In the optical heterodyne technology, beat lights are generated by interference of two lights of slightly different frequency. The beat lights are converted into the electrical signal by a photodiode. In this next, the necessary information is read by the electrical signal.

That is, it is supposed that one light is a measurement signal $S_s$. In particular it is supposed that the other light is a reference signal $S_r$. It is assumed that information was given for a phase and a amplitude of a measurement signal $S_s$. The above information appears to the beat signals generated by signal $S_r$ and signal $S_s$.

The measurement signal is defined in $S_s$, and the reference beam signal is also defined in $S_r$. These signals are represented by the next equation.

$$S_s = a_s \exp\{j(\omega_s t + \varphi_s)\} \quad (A1)$$

$$S_r = a_r \exp\{j(\omega_r t + \varphi_r)\} \quad (A2)$$

The said "$a_s$" is amplitude of the signal $S_s$, moreover the said "$a_r$" is amplitude of the signal $S_r$. The said "$\omega_s$" is frequency of the signal $S_s$, and the said "$\omega_r$" is frequency of the signal $S_r$. The said "$\varphi_s$" is a phase of the signal $S_s$, and the said "$\varphi_r$" is a phase of the signal $S_r$.

An optical power detected by a photodiode is a time average of $|S_s+S_r|^2$. The time average is represented by the next equation.

$$(a_s^2 + a_r^2) + 2a_s a_r \cos[(\omega_s - \omega_r) t + (\varphi_s - \varphi_r)] \quad (A3)$$

The first term of the equation (A3) is a DC component, and the second term of the equation (A3) is an AC component (optical beat signal).

Amplitude $a_r$ is known. Thus, the magnitude ($a_s$) of the measurement signal is measured when the amplitude ($a_s a_r$) of the optical beat signal is detected. Also, phase $\varphi_r$ is known. Thus, the phase $\varphi_s$ of the measurement signal is measured when the phase ($\varphi_s - \varphi_r$) of the optical beat signal is detected.

[prior art documents]

[a patent document]

[patent document 1]
JP2006-293,257
[patent document 2]
JP2001-227,911

SUMMARY OF THE INVENTION

PROBLEM TO BE SOLVED BY THE INVENTION

In late years, the transmission rate of the optical data communication speeds up, and, for example, the communication technology using the optical frequency comb is proposed in various ways (cf. the patent document 1 or 2). In the prior art, as for the amount of information which can be transmitted with 1 channel by limitation of the processing speed of the electric circuit, 100 Gbits/s is a limit. The transmission rate is restricted by the processing rate of the electric circuit.

In the prior art, the amount of information that can be transmitted with 1 channel is 100 Gbits/s at the maximum. It is assumed that transmitting device transmits optical data at the rate of terabit. The processing rate when an electric circuit of the receiving device detects phase cannot be beyond receiving rate of the optical data. Thus, it is not possible to detect a phase of a signal transmitted at rate of terabit substantially. In other words, the optical data communication at terabit rate cannot be implemented in communication technology using optical frequency comb.

The object of the present invention is to provide the relative phase detector which can detect the relative phase of two measurement signals having a predetermined frequency interval using two reference signals fast.
Another object of the present invention is to provide the information reading device which the relative phase detector was applied to.

MEANS TO SOLVE THE PROBLEM

Time change of a signal which changed on a time axis related to phase spectrum and amplitude spectrum on the frequency axis closely, and the inventor looked at this fact. To calculate the relative phase of two measurement signals, the inventor introduced two reference signals of the frequency difference which was the same as a frequency difference of these measurement signals into the calculating equation. In addition, the inventor performed an idea of generating two beat signals. One beat signal is generated by "lower frequency reference signal and lower frequency measurement signal". Also, the other beat signal is generated by "higher frequency reference signal and higher frequency measurement signal". And the inventor obtained a conclusion that the relative phase of two measurement signals could be detected by multiplying these beat signals by. A relative phase detector, relative phase detecting method and information reading device of the present invention were created based on the above thought process.
The relative phase detector of the present invention is described in (3) by a claim (1).

(1)
A relative phase detector which detects a relative phase of two measurement signals that frequencies are different using two reference signals at high-speed, the relative phase detector comprising:

a reference signal generator generating two reference signals having constant frequency difference to each of two reference signals of measurement signals,
a beat signal processor which generates a beat signal between lower frequency measurement signal and lower frequency reference signal and a beat signal between higher frequency measurement signal and higher frequency reference signal from the two measurement signals and the two reference signals, wherein the two beat signals are generated by the two measurement signals and two reference signals respectively, here after generates the square signal of the sum of the said two beat signals,
the relative phase detecting element which detects the relative phase of the two measured signals by taking out DC component from the square signal of the sum.

In the relative phase detector of the present invention, a measurement signal and a reference signal are optical signals, electrical signals or acoustic signals. When a measured signal and a reference signal are optical signals, photoelectric translator which converts an optical signal into an electrical signal in the beat signal processor is possessed. In the case which a measurement signal and a reference signal are optical signals, a photo-electric converter to convert an optical signal into electrical signal is comprised in a beat signal processor.
Also, a measurement signal and a reference signal may be the acoustic signal. In this case, the beat signal processor has a function to convert an acoustic signal into electrical signal, a function to generate beat signals from the electric signal, and a function to multiply two of the beat signals.
(2)
A relative phase detector comprising amplitude detecting element detecting amplitude of the two measurement signals according to claim (1), wherein the relative phase detector removes a constant decided by detection system using one or more detection results of the amplitude detecting element.

(3)
The relative phase detector comprising a signal path length modulator that changes at least one of signal paths length of the reference signal and the measurement signal according to claim (1) or (2), wherein, in the case a relative phase between "0-π" [rad] and a relative phase between "n-2n" [rad] are detected as "relative phases in the appearances" by the relative phase detector, one of these "relative phases in the appearance" is identified as "true relative phase",
a signal path length modulator changes the signal paths length, and the relative phase detector identifies the relative phase that changes in a right direction among two "relative phases in the appearance" as "true relative phase".

In the present invention, "0-π" can mean "less than n more than 0". "π-2π" can mean "less than 2n more than n". Also, in the present invention, "0-π" can mean "less than n more than 0". "2n-n" can mean "less than 2n more greatly than n".
That is, "n" may be included in "0-π", and "n" may be included in "2π-π" . The change of the signal paths length by the signal path length modulator can be implemented by changing signal paths length mechanically. Also, the change of the signal paths length can be implemented by using technology of electro optics (nonlinear optical effect) or it can be implemented by using technology. A relative phase detecting method of the present invention assumes (4)-(6) subject matter.

(4)
A relative phase detecting method detecting a relative phase of two measurement signals that frequencies are different,
generating two reference signals having constant frequency difference to each of two measurement signals,
generating the multiplication signal of two beat signals from the two the measurement signals and the two reference signals,
wherein one beat signal is generated by lower frequency measurement signal and lower frequency reference signal, and the other beat signal is generated by higher frequency measurement signal and higher frequency reference signal,
a decided constant by detection system is removed from DC component of the multiplication signal, a relative phase of two measurement signals is detected.

(5)
A relative phase detecting method according to claim (4) comprising the step to remove a constant decided by detection system, wherein the constant is determined using a detection result of the amplitude of the two measurement signals.

(6)
The relative phase detecting method according to claimed (4) or (5), wherein
in the case a relative phase between "0-π" [rad] and a relative phase between "π-2π"[rad] are detected as "relative phases in the appearances", one of these "relative phases in the appearance" is identified as "true relative phase",
a right direction among two "relative phases in the appearance" is as "true relative phase" by changing a signal paths length.

The relative phase detection technology of the present invention can be applied to information reading device reading information included in the original signal. About two measurement signals in a plurality of measurement signals that frequency is different, a process to detect relative phase and relative magnitude is performed, wherein the two measurement signals are included a original signal.
The information reading device of the present invention assumes (7)-(12) subject matter.

(7)
The information reading device that detects a relative phase and amplitude of two measurement signals in a plurality of measurement signals included in an original signal repeatedly while changing two measurement signals, and reads information included in the original signal,

comprising,

a reference signal generator generating two reference signals having a constant frequency difference to each of two measurement signals,

a beat signal processor generating a multiplication signal two beat signals, wherein one beat signal is generated by two reference signals that frequency is low and two measurement signals that frequency is low, the other beat signal is generated by two reference signals that frequency is high and two measurement signals that frequency is high,"

an amplitude detecting element detecting amplitudes two measurement signals from two beat signals, wherein one beat signal is "the beat signal generated from measurement signal that frequency is low and reference signal that frequency is low" and "the beat signal generated from measurement signal that frequency is high and reference signal that frequency is high, "

a relative phase detector detecting relative phase of two measurement signals, wherein a constant decided by detection system is removed from the DC component of the multiplication signal,

an information extractor reading information included in the original signal from a plurality of relative phases and a plurality of amplitudes, wherein a relative phase detected by the relative phase detector and the amplitude detected by the amplitude detecting element is stored sequentially.

In the information reading device of the present invention, a measurement signal and a reference signal are usually an optical signal, an electrical signal, an acoustic signal same as the case of the relative phase detector.
(8)
The information reading device as claimed in (7) that a constant decided by detection system is removed using a detection result of the amplitude detector.


(9)
A information reading device as claimed in (7), (8), wherein, when the relative phase detector detects a relative phase between "0-$\pi$" [rad] and a relative phase between "$\pi$-2$\pi$[rad] as "relative phases in the appearances", it identifies one of these "relative phases in the appearance" as "true relative phase",

a signal path length modulator changes at least one of the signal path length of the signal path that the reference signal transmits or the signal path length of the signal path that the measurement signal transmits,

when the signal path length is changes by the signal path length modulator,

the relative phase detector identifies the relative phase that changes to a right direction among two "relative phases in the appearance" as "true relative phase".

(10)
The information reading device that detects a relative phase and amplitude of two measurement signals in a plurality of measurement signals included in an original signal in parallel while changing two measurement signals, and reads information included in the original signal,

comprising,

 (a) reference signal generator,
 (b) a beat signal processor (a parallel output),
 (c) each a plurality of relative phase detection units comprising the relative phase detector,

It is amplitude detecting element (d)

 (e) information extractor,

the reference signal generator generates a plurality of reference signals which are the same as the frequency interval of the measurement signal , but the frequency is different with the frequency of the measurement signal,

The beat signal processor generates a plurality of beat signals from a plurality of measurement signals and the pair with a plurality of reference signals.

It can repeat, and the beat signal processor selects two beat signals from these beat signals, and the above beat signal processor generates these multiplication signals, and it is distributed between the relative phase detection unit of plural above.

The amplitude detecting element detects the amplitude of the measurement signal from the amplitude of the beat signal of plural generated above from the pair with the measurement signal and the measurement signal.

The relative phase detector removes constant decided by detection system from the DC component of the multiplication signal with the relative phase detection unit of plural above.

The relative phase of two measurement signals which became basic of the generation of the beat signal of two above is detected,

The information extractor reads information included in the above original signal from the above amplitude detected by the relative phase detected by the relative phase detection unit of plural above and amplitude detecting element.

Note that the information extractor can be assumed an original signal reload department.

In this case, the information reading device of the present invention is used as a signal reshaping device restoring original signal.

(11)
The relative phase detection apparatus as claimed in (10) including removing constant decided by detection system using a detection result of the amplitude detector.

(12)
The information reading device according to claim(10)-(12):

wherein, the relative phase detecting element detects relative phase between 0-n [rad] and relative phase between n-2n [rad] as "relative phase in the appearances", one of these two "relative phase in the appearance" is identified as "true relative phase",

the signal path length modulator changing at least one of the signal paths length of the signal paths where the signal paths length of the signal paths where the reference signal spreads, the measured signal spread,

when it changed signal paths length by the signal path length modulator, the relative phase detecting element identifies relative phase changing into the right direction in response to the change as "true relative phase" among "the relative phase in the appearance" of two above.

EFFECT OF THE INVENTION

In a relative phase detector of the present invention, the relative phase of two measurement signals that frequency is different can be measured using two reference signals at high seed. Even if an absolute phase of each measurement signal is unknown, the measurement is accomplished. In an information reading device of the present invention, a process to detect a relative phase and a relative magnitude are carried out about two measurement signals in a plurality of measurement signals. This process is serial processing or parallel processing. Even if the absolute phase of each measurement signal is thereby unknown, an absolute phase and amplitude of the measurement signal are detected. Thus, information included in an original signal is begun to read. Also, in an information reading device of the present invention, reading of an information included in the high-speed signal is possible, too. For example, a high-speed signal beyond a cutoff frequency of a detection device of an information reading device can read information included in the high speed signal without measuring complicated changes of the signal sequentially. In this case, it is necessary to measure a phase spectrum on a frequency axis and amplitude spectrum.

BRIEF DESCRIPTION OF DRAWINGS

[FIG. 1]

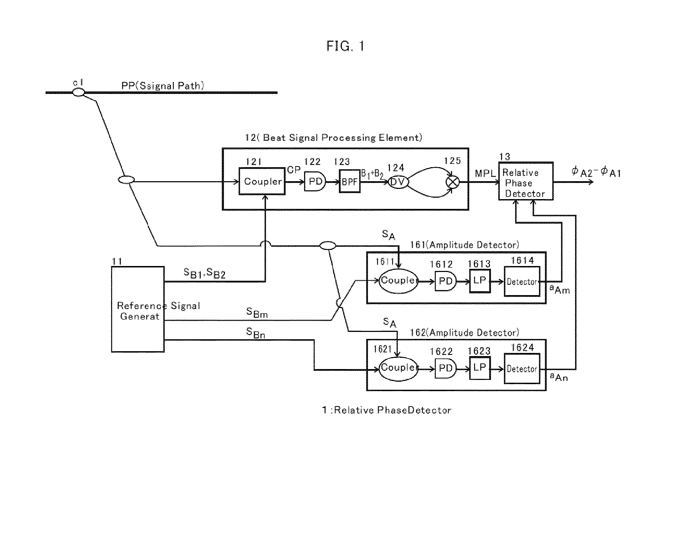

FIG.1 is a block diagram which shows a basic constitution of a relative phase detector of the present invention.
[FIG. 2]

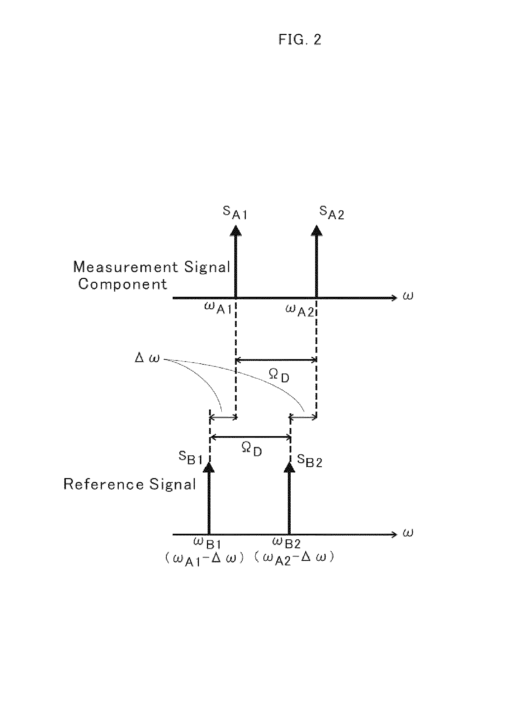

FIG.2 is a figure which shows a relationship between a measurement signal and a reference signal in a frequency axis.

[FIG. 3]

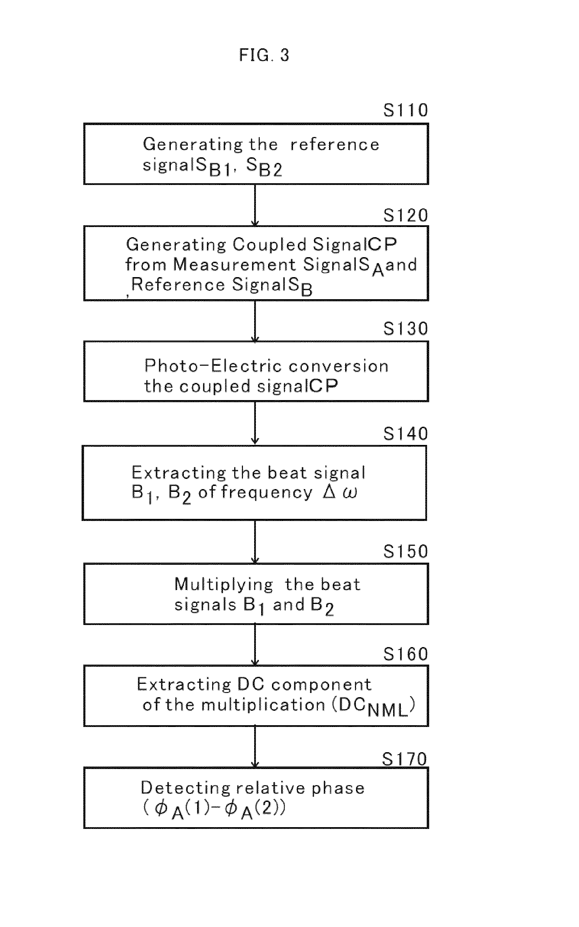

FIG.3 is a flow chart which shows relative phase detecting method of the present invention.
[FIG. 4]

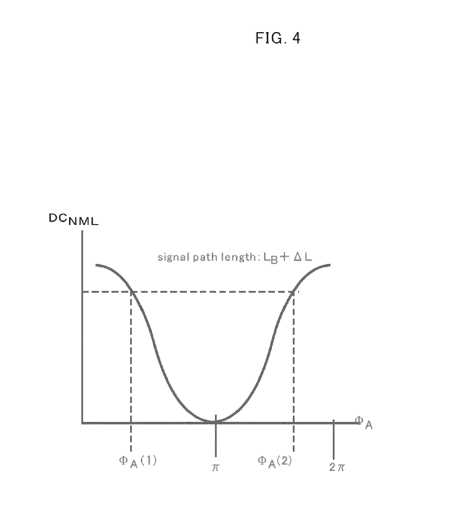

FIG.4 is a figure which shows a relationship between a normalized DC component of a signal DC and a relative phase component of a signal DC of two beat signals, wherein a both components are a multiplication signals of two beat signals.
[FIG. 5]

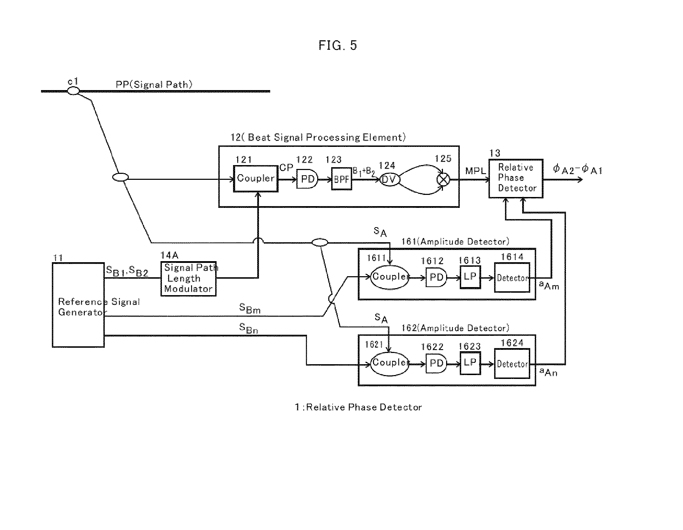

FIG. 5 is a block diagram showing a constitution of a relative phase detector of the present invention. In this relative phase detector, a signal path length modulator is comprised on behind of a reference signal generator.
[FIG. 6]

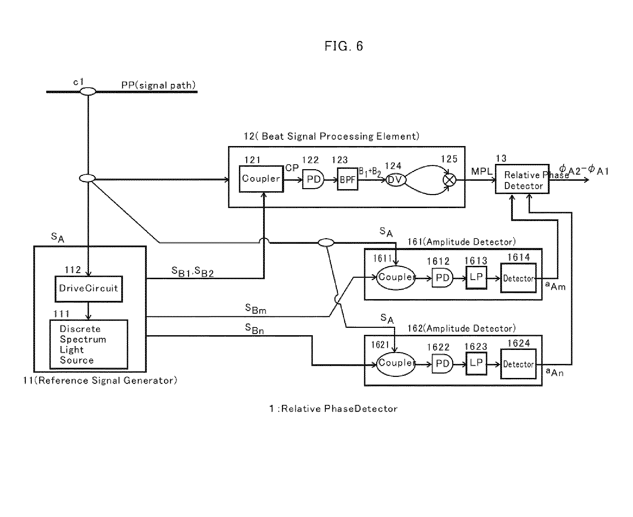

FIG.6 is a block diagram which shows the example which implemented the function that was equal to signal path length modulator by the drive signal of the laser of the reference signal generator.
[FIG. 7]

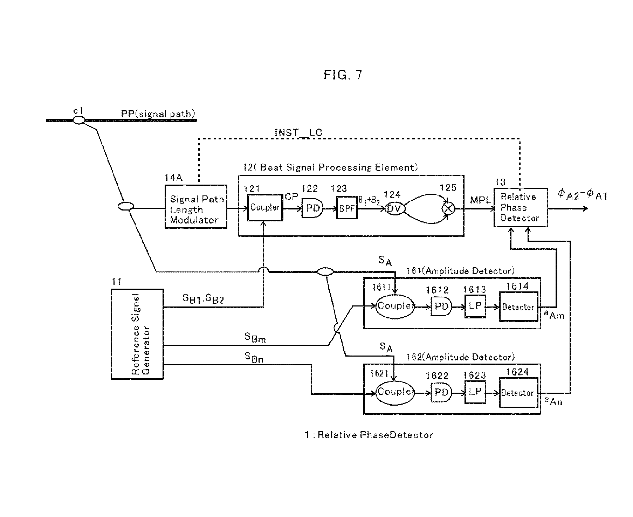

FIG.7 is a block diagram which shows a constitution of a relative phase detector of the present invention which provided a signal path length modulator on a measurement signal path.
[FIG. 8]

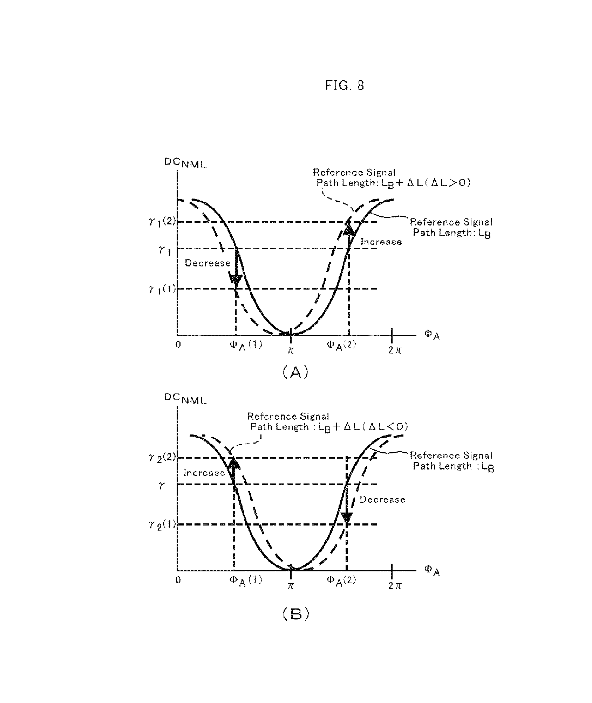

FIG. 8(A) is an illustration to determine "true relative phase". This figure shows relation between normalized DC component and a relative phase component (wherein a reference signal path length was changed). FIG. 8(B) shows relations with normalized DC component and the relative phase component for explanation of the judgments of "the true relative phase" (wherein a measurement signal path length was changed).
[FIG. 9]

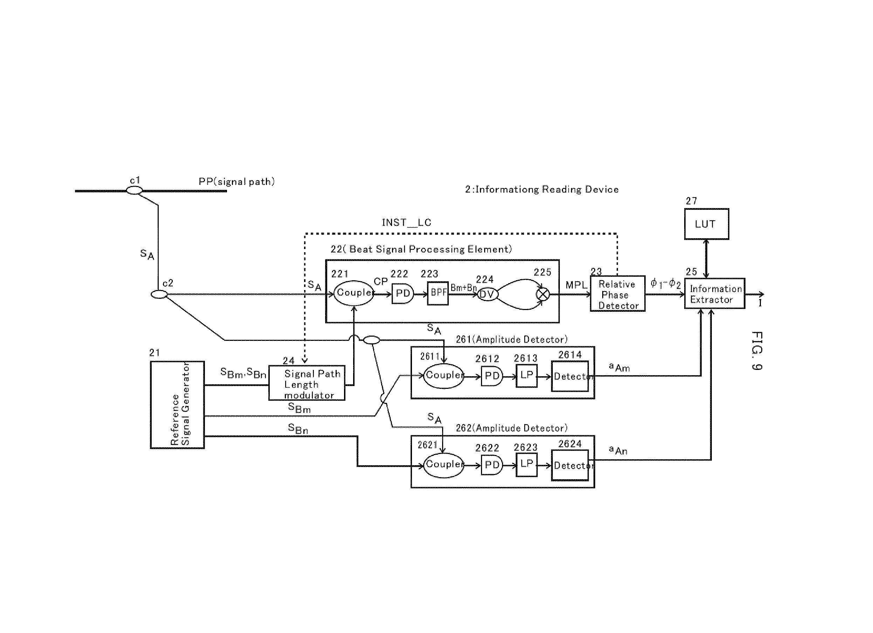

FIG. 9 is a figure showing the examples of an information reading device which a relative phase detection technology of the present invention was applied to.
[FIG. 10]

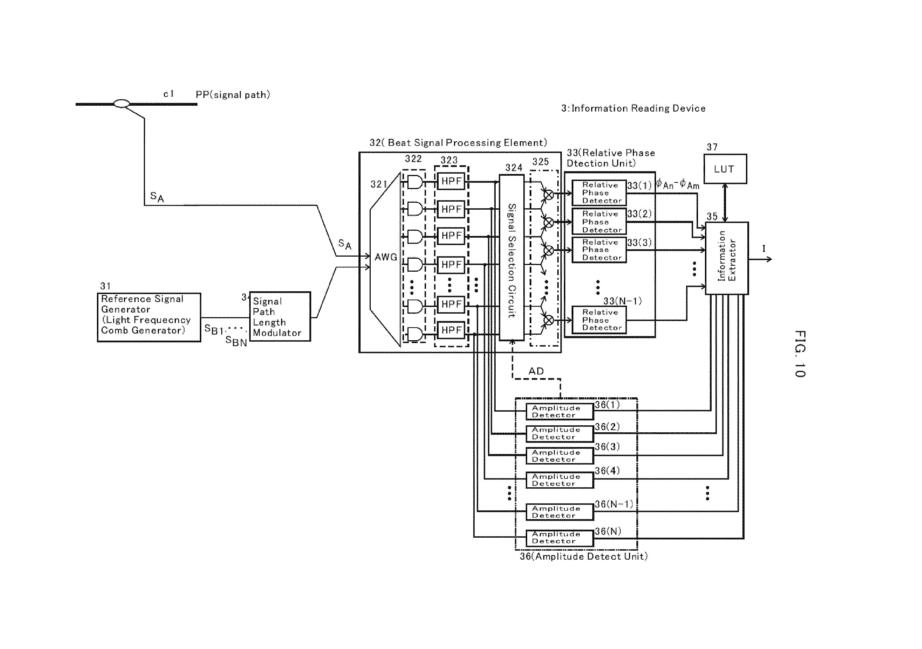

FIG.10 is a figure which shows other examples of an information reading device which a relative phase detection technology of the present invention was applied to.

[mode for carrying out invention]

One embodiment of a relative phase detector and relative phase detecting method is described. Wherein, a measurement signal and a reference signal are optical signals. Note that, in the present specification, an angular frequency $\omega$ is merely called "frequency".

FIG. 1 is a block diagram showing a basic constitution of a relative phase detector of the present invention. FIG. 2 is a figure showing the relations of a measurement signal (measured light) and a reference signal (a reference beam) in the frequency axis.
FIG. 3 is a flow chart showing relative phase detecting method of the present invention. In the following explanations, the processing step numbers in a flow chart of FIG. 3 are added appropriately.

In FIG. 1, the relative phase detector 1 detects a relative phase ($\varphi_{A2}-\varphi_{A1}$) of two measurement signals $S_{A1}$, $S_{A2}$. Wherein, two measurement signals $S_{A1}$, $S_{A2}$ are included in the original signal $S_A$, the frequencies of these signals are different.
The relative phase detector 1 comprises of the reference signal generator 11, the beat signal processing element 12, the detecting element 13 and the amplitude detecting element 161,162.
In this embodiment, two measurement signals $S_{A1}$, $S_{A2}$ are represented as follows.

$$S_{A1} = a_{A1}\exp\{j\ (\omega_{A1}t-\varphi_{A1})\}\quad (B1)$$

$$S_{A2} = a_{A2}\exp\{j\ (\omega_{A2}t-\varphi_{A2})\}\quad (B2)$$

$a_{A1}$: amplitude of $S_{A1}$,
$a_{A2}$: amplitude of $S_{A2}$,
$\omega_{A1}$: frequency of $S_{A1}$,
$\omega_{A2}$: frequency of $S_{A2}$,
$\omega_{A1}$: phases of $S_{A1}$,
$\varphi_{A2}$: phases of $S_{A2}$.

Note that the frequencies ($\omega_{A2}$, $\omega_{A2}$) are known, the phase difference ($\varphi_{A2}$-$\varphi_{A1}$) is unknown. Also, either of $\varphi_{A1}$ and $\varphi_{A2}$ may be known. Both $\varphi_{A1}$ and $\varphi_{A2}$ are usually unknown.

The discrete spectrum light source (a frequency comb light source) is built in the reference signal generator 11. The reference signal generator 11 generates the reference signals $S_{B1}$, $S_{B2}$ (S110).

The reference signals $S_{B1}$, $S_{B2}$ correspond to measurement signals $S_{A1}$, $S_{A2}$ which are included in original signal $S_A$ as a frequency component. The reference signals $S_{B1}$, $S_{B2}$ can be represented as follows.

$$S_{B1} = a_{B1} \exp\{j\ (\omega_{B1}t-\varphi_{B1})\} \quad (B3)$$

$$S_{B2} = a_{B2} \exp\{j\ (\omega_{B2}t-\varphi_{B2})\} \quad (B4)$$

$a_{B1}$: amplitude or $S_{B1}$,
$a_{B2}$: amplitude of $S_{B2}$,
$\omega_{B1}$: frequency of $S_{B1}$,
$\omega_{B2}$: frequency of $S_{B2}$,
$\varphi_{B1}$: phase of $S_{B1}$,
$\varphi_{B2}$: phase of $S_{B2}$.

A value of the phase $\varphi_{B2}$ of the reference signal $S_{B2}$ may be different from a value of the phase $\varphi_{B1}$ of the reference signal $S_{B1}$ ($\varphi_{B1} \neq \varphi_{B2}$). The value of the phase $\varphi_{B2}$ of the reference signal $S_{B2}$ may be the same as a value of the phase $\varphi_{B1}$ of the reference signal $S_{B1}$ ($\varphi_B = \varphi_{B1} = \varphi_{B2}$). In this embodiment, it is supposed that "$\varphi_B = \varphi_{B1} = \varphi_{B2}$" is formed.

The frequency interval ($\Omega_D$) of the reference signals ($S_{B1}$, $S_{B2}$) is the same as the frequency interval of the measurement signals ($S_{A1}$, $S_{A2}$) as shown in FIG. 2.

The middle value ($\omega_{B2}$-$\omega_{B1}$)/2 of the frequency ($\omega_{B1}$) of the reference signal ($S_{B1}$) and the frequency ($\omega_{B2}$) of the reference signal ($S_{B2}$) is set between the frequency ($\omega_{A1}$) of the measurement signal SA1 and the frequency ($\omega_{A2}$) of the measurement signal $S_{A2}$.

In this embodiment, the frequency difference between the measurement signal ($S_{A1}$) and the reference signal ($S_{B1}$) (the frequency difference between the measurement signal ($S_{A2}$) and the reference signal ($S_{B2}$)) is assumed a value ($\Delta\omega$). That is, it is assumed $\{\Delta\omega=\omega_{A1}-\omega_{B1}=\omega_{A2}-\omega_{B2}\}$.

Between $\Delta\omega$ and $\Omega_D$, the next relations are concluded.

$$|\Delta\ \omega|<|\Omega_D|/2 \quad (B5)$$

The reference signals $S_{B1}$, $S_{B2}$ are represented as follows.

$$S_{B1} = a_{B1} \exp\{j(\omega_{A1}-\Delta_\omega)t-\varphi_B\} \quad (B6)$$

$$S_{B2} = a_{B2} \exp\{j(\omega_{A2}-\Delta_\omega)t-\varphi_B\} \quad (B7)$$

The beat signal processing element 12 receives an original signal $S_A$ through the optical divider c1 from the signal path PP.

The beat signal processing element 12 generates the beat signal $B_1$ and the beat signal $B_2$ from the measurement signals $S_{A1}$, $S_{A2}$ and the reference signals $S_{B1}$, $S_{B2}$ included in the original signal $S_A$.

The beat signal $B_1$ is generated by the measurement signal $S_{A1}$ with low frequency and the reference signal $S_{B1}$ with low frequency.

The beat signal $B_2$ is generated by the measurement signal $S_{A2}$ with high frequency and the reference signal $S_{B2}$ with high frequency.

And the beat signal processing element (12) generates the multiplication signal (MPL) of these two beat signals.

In FIG. 1, the beat signal processing element 12 comprises of the coupler 121, the photodiode (PD) 122, the band pass filter (BPF) 123, and divider (DV) 124 and mixer (MX) 125.

The coupler 121 synthesizes the original signal $S_A$ and two reference signals $S_{B1}$, $S_{B2}$, and it generates coupled signal CP (S120). And the photodiode PD122 converts the coupled signal CP into an electrical signal (S130).

The output of the photodiode PD122 includes the beat signal $B_1$ of the measurement signal $S_{A1}$ and the reference signal $S_{B1}$, and the beat signal $B_2$ of the measurement signal $S_{A2}$ and the reference signal $S_{B2}$. Even more particularly, the output of PD122 includes a large number of beats of the original signal $S_A$ and the reference signals $S_{B1}$, $S_{B2}$. The band pass filter BPF123 extracts two beat signals ($B_1$ and $B_2$: frequency $\Delta\omega$) from these beat signals (S140).

A beat signal of frequency $\Delta\omega$ generated by the measurement signal $S_{A1}$ and the reference signal $S_{B1}$ is defined as $B_1$. A beat signal of frequency $\Delta\omega$ generated by the measurement signal $S_{A2}$ and the reference signal $S_{B2}$ is defined as $B_2$. The output of BPF123 includes the following term. $2a_A1a_{B1}\cos\{\Delta\omega t + (\varphi_{A1}-\varphi_B) + cnst_1\} + 2a_{A2}a_{B2}\cos\Delta\omega t + (\varphi_{A2}-\varphi_B) + cnst_2\}$ (B8) $cnst_1$ is represented in the next equation.

$$cnst_1 = (1/c) \times [\omega_{A1}n_{A1}L_A - \omega_{B1}n_{B1}L_B]\, cnst_2 = (1/c) \times [\omega_{A2}n_{A2}L_A - \omega_{B2}n_{B2}L_B])$$

c: velocity of light
$n_A$: refractive index of the measurement signal path
$n_B$: refractive index of reference signal path
$L_A$: measurement signal path length
$L_B$: reference signal path length

The first term of the equation (B8) is an element of the beat signal $B_1$. The second term of the equation (B8) is an element of the beat signal $B_2$. The output (or the beat signal) $B_1$, $B_2$ of the band pass filter BPF123 is distributed between two passes by the divider (DV) 124. The signals distributed between two passes are multiplied by mixer (MX) 125 (S150).

The multiplication signal MPL or output of the mixer (MX) 125 is represented as follows. As described earlier, $\varphi_{B1} = \varphi_{B2}$ is formed in the present embodiment.

$$MPL = (a_{A12}a_{B12} + a_{A22}a_{B22})/2 + a_{A1}a_{A2}a_{B2}a_{B1}\cos\{(\varphi_{A2}-\varphi_{A1}) + (cnst_2 - cnst_1)\} + R(\Delta\omega t)$$

(B9)

$cnst_2 - cnst_1$ of the equation (B9) is represented in the next equation.

$$cnst_2 - cnst_1 = (1/c) \times [(\omega_{A2}n_{A2} - \omega_{A1}n_{A1})L_A - (\omega_{B2}n_{B2} - \omega_{B1}n_{B1})L_B] \quad (B10)$$

Also, R ($\Delta\omega t$) in the equation (B9) is a function depending on the product of the beat frequency and the time. The detecting element 13 extracts a DC component of the multiplication signal MPL as described below (cf. equations (B11), (B12)) (S160). A constant to be decided by the detection system is removed from this DC component. The relative phase ($\varphi_{A2}-\varphi_{A1}$) of two measurement signals ($S_{A1}$, $S_{A2}$) is thereby detected (S170). The DC component (DC) of the multiplication signal MPL is represented as follows by equation (B9).

$$DC = (a_{A1}{}^2a_{B1}{}^2 + a_{A2}{}^2a_{B2}{}^2)/2 + a_{A1}a_{A2}a_{B1}a_{B2}\cos\{(\varphi_{A2}-\varphi_{A1}) + (cnst_2 - cnst_1)\} \quad (B11)$$

Only a cosine portion is taken out from this equation, and it is normalized.
Thus, the normalized DC component $DC_{NML}$ is represented like an equation (B12).
Note that constant $a_{A1}a_{A2}a_{B1}a_{B2}$ is a predetermined value or a measured value.

$$DCNML = \cos\{(\varphi_{A2}-\varphi_{A1}) + (cnst_2 - cnst_1)\} \quad (B12)$$

An element which does not depend on the phase is removed from this normalized DC component DCNML. The element which does not depend on the phase is constant ($cnst_2 - cnst_1$) decided by detection system. The relative phase $\Phi_A$ (= ($\varphi_{A2}-\varphi_{A1}$)) of two measurement signals ($S_{A1}$, $S_{A2}$) is thereby derived. Note that, in the equation (B12), an offset (1/2) is omitted for.

Note that the constant $a_{A1}a_{A2}a_{B1}a_{B2}$ may be known. In this embodiment, it is detected by the amplitude detecting elements 161 and 162. The amplitude detecting element 161 takes the original signal $S_A$ (measurement signal $S_{A1}$, $S_{A2}$, ..., $S_{Ak}$, ... $S_{AN}$), and it takes the reference signal $S_{Bm}$ from the reference signal generator 11.

The amplitude detecting element 161 consists of the coupler 1611, the photodiode (photodiode) 1612, the low pass filter (LPF) 1613 and the detector 1614. The detector 1614 can detect the amplitude $a_{Am}$ of the measurement signal $S_{Am}$ from the beat signal $B_m$. Wherein, the beat signal $B_m$ is generated by the reference signal $S_{Bm}$ and the measurement signal $S_{Am}$. The above similarly, the amplitude detecting element 162 (the comprising coupler 1621, the photodiode PD1622, the low pass filter LPF1623, the detector 1624) can detect the amplitude $a_{An}$ of the measurement signal $S_{An}$ from the beat signal $B_n$. Wherein, the beat signal $B_n$ is generated by the reference signal $S_{Bn}$ and the measurement signal $S_{An}$.

The relations with the normalized DC component $DC_{NML}$ and the relative phase $\Phi_A$ are shown in FIG. 4. As shown in FIG. 4, the detecting element 13 usually detects two relative phases $\Phi_A$ (1), $\Phi_A$ (2) in an appearance about a certain DC component $DC_{NML}$. There is $\Phi_A$ (1) between (0-n) [rad], and there is $\Phi_A$ (2) between (n-2n) [rad]. One of these two "relative phases in the appearance" is "true relative phase". The measurement signals $S_{A1}$, $S_{A2}$ may be known whether $\Phi_A$ is between 0 to n or between n to 2n. In this case, one of the relative phase ($\Phi_A$(1), $\Phi_A$(2)) can be determined as "true relative phase".

The measurement signal $S_{A1}$, $S_{A2}$ may be unknown whether $\Phi_A$ is between (0-n) [rad] or between (n-2n) [rad]. In this case, "true relative phase" can be detected by a relative phase detector. As shown in FIG. 5, the signal path length modulator 14A can be aligned on behind of reference signal generator 11 (on the signal path where the reference signals $S_{B1}$, $S_{B2}$ transmit).

Also, the modulation can be added to a driving signal for the drive circuit 112 of the discrete spectrum light source 111 as shown in FIG. 6. The reference signal generator 11 can thereby have the facility that is equal to the signal path length modulator 14A. In this case, the reference signal generator 11 can receive the synchronizing signal of the measurement signals ($S_{A1}$, $S_{A2}$) from the origin of transmission of the original signal $S_A$. And reference signal generator 11 can generate the synchronizing signal from a measurement signals ($S_{A1}$, $S_{A2}$) directly. Even more particularly, the signal path length modulator 14B can be located on the measurement signal path where the measurement signal ($S_{A1}$, $S_{A2}$) transmits as shown in FIG. 7. In this case, the detecting element 13 can send the distance modulation instruction signal INST_LC to the signal path length modulator 14B.

One of "relative phases in the appearance" $\Phi_A$ (1), $\Phi_A$ (2) shown in FIG. 4 can be identified as "true relative phase" by the signal path length modulator 14A of FIG. 5 or the signal path length modulator 14B of FIG. 7. For example, a value of $cnst_2$-$cnst_1$ of the equation (B10) becomes smaller if the reference signal path length $L_B$ changed longer only micro distance by the signal path length modulator 14A of FIG. 5.

On the contrary, a value of $cnst_2$-$cnst_1$ of the equation (B10) becomes larger if the reference signal path length $L_B$ changed shorter only micro distance by the signal path length modulator 14A of FIG. 5. Also, a value of $cnst_2$-$cnst_1$ of the equation (B10) becomes larger if the reference signal path length $L_A$ changed longer only micro distance by the signal path length modulator 14B of FIG. 7. On the contrary, a value of $cnst_2$-$cnst_1$ of the equation (B10) becomes smaller if the reference signal path length $L_A$ changed shorter only micro distance by the signal path length modulator 14B of FIG. 7.

For example, in the relative phase detector 1 of FIG. 5, the value of DCNML is assumed to be $\gamma$. Also, in an appearance, it is supposed that two relative phases $\Phi_A$ (1), $\Phi_A$ (2) were detected (cf. FIG. 4). In this case, by the signal path length modulator 14A, the reference signal path length $L_B$ can be changed into $L_B$+$\Delta L$ ($\Delta L$> 0). As shown in FIG. 8(A), the signal paths long characteristic varies from $L_B$ (solid line) to $L_B$+$\Delta L$ (broken line). If the DC component $DC_{NML}$ decreases to $\gamma$ (1) then, it can be determined that $\Phi_A$(1) is "true relative phase". If the DC component $DC_{NML}$ increases in $\gamma$ (2) it can be determined that $\Phi_A$(2) is "true relative phase". Also, by signal path length modulator 14A the reference signal path length $L_B$ can be changed into $L_B$+$\Delta L$ ($\Delta L$ <0). As shown in FIG. 8(A), the signal paths long characteristic varies from $L_B$ (a solid line) to $L_B$+$\Delta L$ (broken line).

If the DC component $DC_{NML}$ decreases to $\gamma$ (1) then, it can be determined that $\Phi_A$ (2) is "true relative phase". If the DC component $DC_{NML}$ increases in $\gamma$ (2) it can be determined that $\Phi_A$ (1) is "true relative phase".

As discussed above, in the relative phase detector 1, the processor can calculate only a relative phase with the detecting element 13. And the processor does not be required operation or a calculation about the other processing (processing for the coupler 121, PD122, BPF123, DV124 and MX125). Thus, detection (the detection that or is phase) of the relative phase can be performed at high speed.

Other examples of the information reading device which a relative phase detection technology of the present invention was applied to are described below. In this example, a measurement signal and a reference signal are optical signals. The information reading device 2 works to detect a relative phase and amplitudes about two measurement signals ($S_{Am}$, $S_{An}$) in a plurality of measurement signals ($S_{A1}$, $S_{A2}$, ..., $S_{Ak}$, ..., $S_{AN}$) as described below in FIG. 9. The measurement signals ($S_{A1}$, $S_{A2}$, ..., $S_{Ak}$, ... $S_{AN}$) are included in the original signal $S_A$ as frequency components. The frequency interval of the measurement signals is $\Omega_D$. While changing the combination of the measured signals the above processes (serial processing) are repeated. The information included in the original signal $S_A$ are begun to read.

The information reading device 2 consists of the reference signal generator 21, the beat signal processing element 22, the relative phase detecting element 23, the amplitude detecting element 261,262, the information extraction department 25, the look up table LUT27 and the signal path length modulator 24. In this example, original signal $S_A$

(component includes $S_{A1}$, $S_{A2}$, ..., $S_{Ak}$, ... $S_{AN}$) is sent out again and again several times, and the information reading device 2 can receive the same measurement signal several times.

The reference signal generator 21 includes a discrete spectrum light source same as the reference signal generator 11 shown in FIG. 1.

The reference signal generator 21 can select two reference signals sequentially in combination like ($S_{B1}$ and $S_{B2}$), ($S_{B2}$ and $S_{B3}$), ..., (with $S_{Bk}$ $S_{B(k+1)}$), ..., ($S_{B (N-1)}$ and $S_{BN}$). The two measurement signals, ($S_{A1}$ and $S_{A2}$), ($S_{A2}$ and $S_{A3}$), ..., (with $S_{Ak}$ $S_{A (k+1)}$), ..., ($S_{A (N-1)}$ and $S_{AN}$), are detected.

The frequency of $S_{Aj}$ and the frequency of $S_{Bj}$ are different (j = 1, 2, 3, ..., N). However, the value of $[S_{B(k-1)}\text{-}S_{Bk}]$ and the value of $[S_{A(k-1)}\text{-}S_{Ak}]$ are the same (the value is $\Omega_D$).

With the case that a certain measurement signal $S_{A (x+1)}$ is indefinite, the reference signal generator 21 can select the pair of $S_{Bx}$ and $S_{B (x+2)}$. For example, in the case which there is not a measured signal of frequency $\omega_{B(x+1)}$ corresponding to the $S_{B(x+1)}$, the measured signal $S_{A(x+1)}$ is indefinite. In this case, $S_{Ax}$ and $S_{A(x+2)}$ are generated, and the relative phase between $S_{Bx}$ and $S_{B (x+2)}$ is detected.

It can be determined whether measurement signal $S_{A(x+1)}$ is indefinite as follows. At first the relative phase between $S_{Ak}$ and the $S_{A(k+1)}$ is detected. Then, the amplitude $a_{Ak}$, $a_{A(k+1)}$ are detected. Hereafter, it is determined whether a value of amplitude $a_{Ak}$ or $a_{A(k+1)}$ is 0 in data processing. The amplitude $S_{Ak}$ is indefinite if the value of the amplitude $a_{Ak}$ is zero. The amplitude $S_{A(k+1)}$ is indefinite if the value of the amplitude $a_{Ak(k+1)}$ is zero. In this example, the information reading device 2 receives the original signal $S_A$ several times as previously described. Wherein, the original signal $S_A$ includes $S_{A1}$, $S_{A2}$, ..., $S_{Ak}$, ..., $S_{AN}$.

Thus, amplitude $a_{Ak}$, $a_{A(k+1)}$ are detected, and it is judged whether each of the amplitudes $S_{Ak}$, $S_{A (k+1)}$ is indefinite. The relative phase is detected if all of amplitudes are not indefinite. The relative phase is detected in next time if any of amplitudes is indefinite. In the time, two measurement signals (except the measurement signals judged to be indefinite) are chosen, and the relative phase is detected with the same manner above.

In this example, an original signal $S_A$ may be sent out only one time. That is, the information reading device 2 may receive the same measurement signal only one time. In this case, the delay circuit is prepared for the relative phase detection system. For example, the delay circuit is prepared to the appropriate part of the beat signal processor 22. The amplitude $a_{Ak}$ of measurement signal $S_{Ak}$ and the amplitude $a_{Ak}$ of measurement signal $S_{A (k+1)}$) can be detected ahead of the detection of the relative phase by comprising as above.

The beat signal processing element 22 generates the multiplication signal $MPL_{m/n}$ from two measurement signals ($S_{Am}$, $S_{An}$) and two reference signals ($S_{Bm}$, $S_{Bn}$). The multiplication signal $MPL_{m/n}$ is multiplication of the beat signal $B_m$ and the beat signal $B_n$. The beat signal $B_m$ is generated by the measurement signal $S_{Am}$ and the reference signal $S_{Bm}$, the beat signal $B_n$ is generated by the measurement signal $S_{An}$ and the reference signal $S_{Bn}$. The beat signal processing element 22 comprises of the coupler 221, PD222, BPF223, DV224 and MX225. These are the same as the coupler 121, PD122, BPF123, DV124 and MX125 in the beat signal processing element 12 shown fig. 1.

The relative phase detecting element 23 removes the constant ($cnst_n\text{-}cnst_m$) from DC component $DC_{m/n}$ of the multiplication signal $MPL_{m/n}$. Wherein, the constant ($cnst_n\text{-}cnst_m$) is decided depending on the detection system.

And the relative phase detecting element 23 detects the relative phase ($\varphi_{An}\text{-}\varphi_{Am}$) of two measurement signals $S_{Am}$, $S_{An}$. The relative phase detecting element 23 is the same as detecting element 13 shown in FIG. 1. In this example, the relative phase detecting element 23 detects two "relative phases in the appearance" as described in FIG. 8(A), (B). The relative phase detecting element 23 can identify one of two "relative phases in the appearance" as "true relative phase" using the signal path length modulator 24.

The amplitude detecting element 261 inputs the original signal $S_A$ (measurement signal $S_{A1}$, $S_{A2}$, ..., $S_{Ak}$, ... $S_{AN}$), and it inputs the reference signal $S_{Bm}$ from the reference signal generator 21.

The amplitude detecting element 261 consists of coupler 2611, photodiode (photodiode) 2612, low pass filter (LPF) 2613 and detector 2614. Detector 2614 can detect amplitude $a_{Am}$ of measurement signal $S_{Am}$ from beat signal $B_m$ of reference signal $S_{Bm}$ and measurement signal SAm.

Amplitude detecting element 262 takes original signal $S_A$ (measurement signal $S_{A1}$, $S_{A2}$, ..., $S_{Ak}$, ... $S_{AN}$), and reference signal $S_{Bn}$ is taken from reference signal generator 21 likewise.

Amplitude detecting element 262 consists of coupler 2621, PD2622, LPF2623 and detection circuit 2624.

Detecting element 2624 can detect amplitude $a_{An}$ of measurement signal $S_{An}$ from beat signal $B_n$ of reference signal $S_{Bn}$ and measurement signal $S_{An}$.

Note that, in the example, amplitude detecting element 261 detected amplitude $a_{Am}$, and amplitude detecting element 262 detected amplitude $a_{An}$.

As mentioned earlier, in this example, original signal $S_A$ is sent out several times again and again. Information reading device 2 can receive the same measurement signal several times. Thus, amplitude $a_{Am}$ is detected in a certain time, and $a_{An}$ can be detected by the next time.

The relative phase ($\varphi_{An}\text{-}\varphi_{Am}$) is detected by relative phase detecting element 23, and amplitude $a_{Am}$, $a_{An}$ are detected by amplitude detecting element 26. Information extraction department 25 stores relative phase ($\varphi_{An}\text{-}\varphi_{Am}$) and

amplitude $a_{Am}$, $a_{An}$ sequentially. And the information extractor 25 reads information I that is included in the original signal SA from plurality of relative phases and a plurality of amplitudes.

That is, the phase of a certain measurement signal can be set, for example, of zero [rad]. The phase of other measurement signals can be established based on this. Therefore, information extraction department 25 can determine measurement signal $S_{Ak}$ (k = 1,2, ..., N) from the detected phase and amplitude as follows.

$$S_{Ak}' = a_{Ak}\exp\{j\ (\omega_{Ak}t+\varphi_{Ak}')\}\ \ (B13)$$

(k = 1,2, ..., N)
$\varphi_{Ak}$ : a phase when the phase of a certain measurement signal was defined to zero (0 [rad]).
$S_{Ak}'$ : signal when measurement signal $S_{Ak}$ has this phase.
Therefore, the original signal $S_A$ is reproduced by calculating ΣSAk' (from k = 1 to N).

Note that the differences between phase $\varphi_{Ak}$ and phase $\varphi_{Ak}'$ are the same about all k. Thus, $\Sigma S_{Ak}'$ is the same as original signal $S_A$ substantially.

Also, information I is comprised of sixteen kinds of original signals when the original signal $S_A$ is a packet of four bits. In this case, the information extraction department 25 connects detected information I with the relative phase and the amplitude, and look up table (LUT) 27 can store the information I. The information extraction department 25 can thereby detect the information I without calculating $\Sigma S_{Ak}'$, if phase $\Phi_{Ak}$ of $S_{Ak}$ and phase $\Phi_{Ak}'$ of $S_{Ak}'$ can be known.

Other example of the information reading device is described below. Wherein, a relative phase detection technology of the present invention is applied to the information reading device. In this particular example, a measurement signal and a reference signal are optical signals. In FIG. 10 the information reading device 3 detects the relative phase and the amplitude between two measured signals $S_{An}$, $S_{A(n+1)}$.
Two measured signals ($S_{An}$, $S_{A(n+1)}$) are two signals in a plurality of the measured signals ($S_{A1}$, $S_{A2}$, ..., $S_{Ak}$, ... $S_{AN}$). The frequency interval $\Omega_D$ of two measured signals next to each other is different. The measurement signals ($S_{A1}$, $S_{A2}$, ..., $S_{Ak}$, ... $S_{AN}$) are the signals which are included in the original signal $S_A$ as frequency components. The information reading device 3 performs the above process in parallel (parallel processing is performed). On the occasion of the processing, the combination of the measured signal is changed. The information reading device 3 can thereby read the information included in the original signal $S_A$. Note that, in this example the original signal $S_A$ is sent out again and again. Thus, the information reading device 3 can receive the same measurement signal several times.

The information reading device 3 is comprised of the reference signal generator 31, the beat signal processor 32, the relative phase detection unit 33 (comprising a plurality of relative phase detector 33(k) (k = 1,2,3,... ,N-1)) of (N-1), the signal path length modulator 34, the information extractor 35 and the amplitude detecting element 36 and the look up table LUT37. The relative phase detection unit 33 consists of a plurality of the relative phase detector 33 (k) (k = 1,2,3, ... ,N-1).

The reference signal generator 31 generates the reference signals of N ($S_{B1}$, $S_{B2}$, ..., $S_{Bk}$, ..., $S_{BN}$). The reference signal generator 31 obtains the information on the frequencies and the frequency intervals of the reference signals ($S_{B1}$, $S_{B2}$, ..., SBk, ..., $S_{BN}$) beforehand. This information is based on a communication technical standard. The reference signals ($S_{B1}$, $S_{B2}$, ..., $S_{Bk}$, ..., $S_{BN}$) do not accord with the frequency of measurement signals ($S_{A1}$, $S_{A2}$, ..., $S_{Ak}$, ... $S_{AN}$). However, the frequency interval of the reference signal is the same as the frequency interval $\Omega_D$ of the measured signal.

The beat signal processing element 32 generates the beat signal $B_1$, $B_2$, ..., $B_N$. The beat signals ($B_1$, $B_2$, ..., $B_N$) are generated from the measurement signals ($S_{A1}$, $S_{A2}$, ..., $S_{Ak}$, ... $S_{AN}$) and the reference signals ($S_{B1}$, $S_{B2}$, ..., $S_{Bk}$, ... $S_{BN}$). A beat signal is generated from a measurement signal and a reference signal. The two frequencies are close in mutually. And the beat signal processing element 32 selects two beat signals in these a plurality of beat signals. By this selection, the redundant selection of the same beat signal is permitted. The beat signal processing element 32 generates the multiplication signal of two beat signals. And these multiplication signals are distributed between relative phase detection unit 33.

In FIG. 10, the beat signal processing element 32 comprises the arrayed-waveguide grating (AWG) 321, the PD (photodiode) group 322, the beat signal extractor 323, the signal selection circuit 324 and mixer group 325. The arrayed-waveguide grating (AWG) 321 has two input terminals and N outputs. The Photodiode group 322 consists of N photodiodes (PD) located for an output side. The beat signal extractor 323 comprising high pass filters. Each high pass filter extracts a beat signal between a reference signal and a measurement signal from an output signal of PD group 322. The signal selection circuit 324 selects two beat signals from the output signals of beat signal extractor 323, respectively permitting repetition. The mixer group 325 consists of the mixers of (N-1) units to multiply two signals in the output signals of signal selection circuit 324.

The frequency of beat signal between a reference signal and a measurement signal is $\Delta\omega$. The output signals of photodiode group 322 include various kinds of beat signals other than the beat signals of frequency $\Delta\omega$. The beat

signal extraction part 323 can extract the beat signals that frequency is $\Delta\omega$ from these various kinds of beat signals.

In the signal selection circuit 324, a phase is detected as a relative phase. Thus, for example, the beat signal is not connected with the phase if the beat signal is selected like ($B_1$ and $B_2$), ($B_3$ and $B_4$), ($B_5$ and $B_6$), ... , ($B_{N-1}$ and $B_N$) from a beat signal ($B_1$, $B_2$, ... , $B_N$).

Therefore, for example, the beat signals are selected like ($B_1$ and $B_2$), ($B_2$ and $B_3$), ($B_3$ and $B_4$), ..., ($B_{N-1}$, $B_N$) from ($B_1$, $B_2$, ... , $B_N$) "permitting repetition". All the beat signals are connected through the phases in this way.

When a certain measurement signal $S_{A\,(x+1)}$ is indefinite, the reference signal $S_{B\,(x+1)}$ does not contribute to the generation of the beat signal.

As already described, in this example the information reading device 3 can receive the same measured signal many times. Thus, the signal selective circuit 324 detects the amplitude in a certain time, it can thereby know the unsettled signal beforehand. The signal selective circuit 324 can use the detection result AD with the amplitude detecting element 36 in the next time.

In the example above, signal selective circuit 324 can calculate a multiplication signal about the combination of two assumed beat signals. The two beat signals are chosen from the beat signals $B_1$, $B_2$, $B_3$, ..., $B_N$ which the beat signal processor 32 generated. That is, phase cannot be detected when a one amplitude detection level of two beat signals is zero.

In this example, the original signal $S_A$ ($S_{A1}$, $S_{A2}$, ..., $S_A k$, ..., $S_{AN}$) may be sent out once. In this case, the information reading device 2 can receive only one time of the same measured signal. Thus, the relative phase detection system can be provided with a delay circuit. For example, a delay circuit is provided at the appropriate position of the beat signal processor 32 (a position after PD122 to be described below). The measured signal $S_{Ak}$, amplitude $a_{Ak}$ of the $S_{A\,(k+1)}$, $a_{A(k+1)}$ can be thereby detected before than the detection of the relative phase.

The mixers of (N-1) units to comprise mixer group 325 mix two beat signals. And the multiplication signal $MPL_{m/n}$ is sent out to the relative phase detector 33 (k) (k=1,2,3,... ,N-1), respectively. Wherein the multiplication signal $MPL_{m/n}$ is the multiplication signal of a m-th beat signal and the n-th beat signal.

Decided constant ($cnst_n$-$cnst_m$) is removed from DC component $DC_{m/n}$ of multiplication signal $MPL_{m/n}$ with relative phase detecting element 33 (k) by detection system. The constant ($cnst_n$-$cnst_m$) decided by the detection system is removed from DC component $DC_{m/n}$ of the multiplication signal $MPL_{m/n}$. And the relative phase ($\varphi_{An}$-$\varphi_{Am}$) of two measured signals $S_{Am}$, $S_{An}$ is detected. In this example, the relative phase detecting element 33 (k) detects two "relative phases in the appearance" as described in FIG. 8(A), (B). One of "relative phases in the appearance" is identified as "true relative phase" using the signal path length modulator 34.

The amplitude detection unit 36 is comprised of the amplitude detecting element 36 (k) (k = 1,2,3, ..., N) of the N units. The amplitude detection unit 36 can detect the amplitude $a_{Aj}$ of the measurement signal $S_{Aj}$ from the amplitude of beat signal $B_j$. The information extractor 35 stores the relative phase ($\varphi_{An}$-$\varphi_{Am}$) detected by the relative phase detection unit 33 (k), it also stores the amplitude $a_{Am}$, $a_{An}$ detected by the amplitude detecting element 36. The information extractor 35 detects the signal $S_{Ak}$' corresponding to the measured signal from a plurality of the relative phases and the amplitudes. Wherein, the relative phases and the amplitudes are memorized in a data storage (LUT37). And the information extractor 35 calculates $\Sigma S_{Ak}$', and the information I included in the original signal $S_A$ is read out.

In this example, the generating of the beat signals by using AWG321, the multiplication of the beat signals, the detection processing of the relative phase are possible. Also, the amplitude is detected in parallel by using AWG321, as a result high-speed operation is possible. The information I where the information extractor 35 detected can be stored LUT37 in this example. Wherein, a detected information I is linked the relative phase and the amplitude. The information extractor 35 can thereby detect the information I without calculating $\Sigma S_{Ak}$'.

Note that, in the information reading device, a key can be embedded in a value of the frequency. In this case, an encrypted information I can be embedded in original signal $S_A$.

DENOTATION OF REFERENCE NUMERALS

| | |
|---|---|
| 1 | relative phase detector Two or three information reading device |
| 11, 21, 31 | reference signal generator |
| 12, 22, 32 | beat signal processing elements |
| 13 | detecting elements |
| 14A, 14B, 24, 34 | signal path length modulator |
| 23, 33 | (k) relative phase detecting elements |
| 25, 35 | information extraction department |
| 26, 36 (k), 36,261,262 | amplitude detecting elements |
| 27, 37 | look-up table (LUT) |

| | |
|---|---|
| 33 | relative phase detection units |
| 36 | amplitude detection units |
| 111 | discrete spectrum light source |
| 112 | drive circuits |
| 121, 221, 2611, 2621 | coupler |
| 122, 222, 311, 2612, 2622 | photodiode (photodiode) |
| 123,223 | bandpass filters (BPF) |
| 124 | dividers |
| 125 | mixers |
| 124,224 | dividers (DV) |
| 125,225 | mixers (MX) |
| 321 | arrayed-waveguide gratings (AWG) |
| 322 | photodiode (photodiode) groups |
| 323 beat | signal extraction parts |
| 324 | signal selection circuit |
| 325 | mixers group |
| 2614, 2624 | detecting elements |
| 2611 | coupler |
| 2613, 2623 | low pass filters (LPF) |
| 161,162 | amplitude detecting element |
| 1611, 1621 | coupler |
| 1612, 1621, 2612, 2621 | photodiode (photodiode) |
| 1613, 1623, 2613, 2623 | low pass filter (LPF) |
| 1614, 1624, 2614, 2624 | detector |

**Claims**

1. A relative phase detector which detects a relative phase of two measurement signals that frequencies are different using two reference signals at high-speed, the relative phase detector comprising:

   a reference signal generator generating two reference signals having constant frequency difference to each of two reference signals of measurement signals,
   a beat signal processor which generates a beat signal between lower frequency measurement signal and lower frequency reference signal and a beat signal between higher frequency measurement signal and higher frequency reference signal from the two measurement signals and the two reference signals, wherein the two beat signals are generated by the two measurement signals and two reference signals respectively, here after generates the square signal of the sum of the said two beat signals,
   the relative phase detecting element which detects the relative phase of the two measured signals by taking out DC component from the square signal of the sum.

2. A relative phase detector comprising amplitude detecting element detecting amplitude of the two measurement signals according to claim 1, wherein the relative phase detector removes a constant decided by detection system using one or more detection results of the amplitude detecting element.

3. The relative phase detector comprising a signal path length modulator that changes at least one of signal paths length of the reference signal and the measurement signal according to claim 1 or 2, wherein in the case a relative phase between "0-π" [rad] and a relative phase between "n-2n" [rad] are detected as "relative phases in the appearances" by the relative phase detector, one of these "relative phases in the appearance" is identified as "true relative phase",
   a signal path length modulator changes the signal paths length, and the relative phase detector identifies the relative phase that changes in a right direction among two "relative phases in the appearance" as "true relative phase".

4. A relative phase detecting method detecting a relative phase of two measurement signals that frequencies are different,
   generating two reference signals having constant frequency difference to each of two measurement signals,
   generating the multiplication signal of two beat signals from the two the measurement signals and the two reference signals, wherein one beat signal is generated by lower frequency measurement signal and lower frequency reference signal, and the other beat signal is generated by higher frequency measurement signal and higher frequency reference signal,
a decided constant by detection system is removed from DC component of the multiplication signal, a relative phase of two measurement signals is detected.

5. A relative phase detecting method according to claim 4 comprising the step to remove a constant decided by detection system, wherein the constant is determined using a detection result of the amplitude of the two measurement signals.

6. The relative phase detecting method according to claimed 4 or 5, wherein, in the case a relative phase between "0-π" [rad] and a relative phase between "π-2π"[rad] are detected as "relative phases in the appearances", one of these "relative phases in the appearance" is identified as "true relative phase",
a right direction among two "relative phases in the appearance" is as "true relative phase" by changing a signal paths length.

7. The information reading device that detects a relative phase and amplitude of two measurement signals in a plurality of measurement signals included in an original signal repeatedly while changing two measurement signals, and reads information included in the original signal,
comprising, a reference signal generator generating two reference signals having a constant frequency difference to each of two measurement signals,
a beat signal processor generating a multiplication signal two beat signals, wherein one beat signal is generated by two reference signals that frequency is low and two measurement signals that frequency is low, the other beat signal is generated by two reference signals that frequency is high and two measurement signals that frequency is high,"
an amplitude detecting element detecting amplitudes two measurement signals from two beat signals, wherein one beat signal is "the beat signal generated from measurement signal that frequency is low and reference signal that frequency is low" and "the beat signal generated from measurement signal that frequency is high and reference signal that frequency is high, "
a relative phase detector detecting relative phase of two measurement signals, wherein a constant decided by detection system is removed from the DC component of the multiplication signal,
an information extractor reading information included in the original signal from a plurality of relative phases and a plurality of amplitudes, wherein a relative phase detected by the relative phase detector and the amplitude detected by the amplitude detecting element is stored sequentially.

8. The information reading device as claimed in (7) that a constant decided by detection system is removed using a detection result of the amplitude detector.

9. A information reading device as claimed in (7), (8), wherein,
when the relative phase detector detects a relative phase between "0-π" [rad] and a relative phase between "π-2π [rad] as "relative phases in the appearances", it identifies one of these "relative phases in the appearance" as "true relative phase",
a signal path length modulator changes at least one of the signal path length of the signal path that the reference signal transmits or the signal path length of the signal path that the measurement signal transmits,
when the signal path length is changes by the signal path length modulator,
the relative phase detector identifies the relative phase that changes to a right direction among two "relative phases in the appearance" as "true relative phase".

10. The information reading device that detects a relative phase and amplitude of two measurement signals in a plurality of measurement signals included in an original signal in parallel while changing two measurement signals, and reads information included in the original signal,
comprising,

    (a) reference signal generator,
    (b) a beat signal processor (a parallel output),
    (c) each a plurality of relative phase detection units comprising the relative phase detector,

It is amplitude detecting element

    (d) (e) information extractor,

the reference signal generator generates a plurality of reference signals which are the same as the frequency interval of the measurement signal , but the frequency is different with the frequency of the measurement signal,
the beat signal processor generates a plurality of beat signals from a plurality of measurement signals and the pair with a plurality of reference signals.

11. The relative phase detection apparatus according to claim 10 including removing constant decided by detection system using a detection result of the amplitude detector.

12. The information reading device according to claim 10-12:

wherein, the relative phase detecting element detects relative phase between 0-n [rad] and relative phase between n-2n [rad] as "relative phase in the appearances", one of these two "relative phase in the appearance" is identified as "true relative phase",
the signal path length modulator changing at least one of the signal paths length of the signal paths where the signal paths length of the signal paths where the reference signal spreads, the measured signal spread,
when it changed signal paths length by the signal path length modulator, the relative phase detecting element identifies relative phase changing into the right direction in response to the change as "true relative phase" among "the relative phase in the appearance" of two above.

FIG. 1

1 : Relative PhaseDetector

FIG. 2

$S_{A1}$  $S_{A2}$

Measurement Signal
Component

$\omega$

$\omega_{A1}$  $\omega_{A2}$

$\Delta\omega$

$\Omega_D$

$\Omega_D$

$S_{B1}$  $S_{B2}$

Reference Signal

$\omega$

$\omega_{B1}$  $\omega_{B2}$
$(\omega_{A1}-\Delta\omega)$  $(\omega_{A2}-\Delta\omega)$

FIG. 3

S110

Generating the reference signal $S_{B1}$, $S_{B2}$

S120

Generating Coupled Signal CP from Measurement Signal $S_A$ and Reference Signal $S_B$

S130

Photo-Electric conversion the coupled signal CP

S140

Extracting the beat signal $B_1$, $B_2$ of frequency $\Delta\omega$

S150

Multiplying the beat signals $B_1$ and $B_2$

S160

Extracting DC component of the multiplication ($DC_{NML}$)

S170

Detecting relative phase ($\phi_A(1) - \phi_A(2)$)

FIG. 4

FIG. 5

PP(Signal Path)
c1

12( Beat Signal Processing Element)

121 CP 122 123 B$_1$+B$_2$ 124 125 MPL 13
Coupler → PD → BPF → DV → ⊗ → Relative Phase Detector → $\phi_{A2}$ − $\phi_{A1}$

S$_A$
161(Amplitude Detector)
1611 1612 1613 1614
Coupler → PD → LP → Detector → $^a$A$_m$

11
S$_{B1}$,S$_{B2}$
14A
Signal Path Length Modulator
Reference Signal Generator

S$_{Bm}$

S$_{Bn}$

S$_A$
162(Amplitude Detector)
1621 1622 1623 1624
Coupler → PD → LP → Detector → $^a$A$_n$

1 : Relative Phase Detector

21

EP 2 495 541 A1

FIG. 6

22

EP 2 495 541 A1

FIG. 7

FIG. 8

(A)

(B)

FIG. 9

FIG. 10

<table>
<tr><td colspan="2" align="center">**INTERNATIONAL SEARCH REPORT**</td><td>International application No.<br>PCT/JP2010/055619</td></tr>
</table>

| A. CLASSIFICATION OF SUBJECT MATTER |
|---|
| *G01J9/02*(2006.01)i |
| According to International Patent Classification (IPC) or to both national classification and IPC |

| B. FIELDS SEARCHED |
|---|
| Minimum documentation searched (classification system followed by classification symbols)<br>G01J9/00-G01J9/04, H04B10/00-H04B10/30 |
| Documentation searched other than minimum documentation to the extent that such documents are included in the fields searched<br>Jitsuyo Shinan Koho    1922-1996   Jitsuyo Shinan Toroku Koho  1996-2010<br>Kokai Jitsuyo Shinan Koho  1971-2010   Toroku Jitsuyo Shinan Koho  1994-2010 |
| Electronic data base consulted during the international search (name of data base and, where practicable, search terms used)<br>JSTPlus(JDreamII) |

| C. DOCUMENTS CONSIDERED TO BE RELEVANT |
|---|

| Category* | Citation of document, with indication, where appropriate, of the relevant passages | Relevant to claim No. |
|---|---|---|
| X | WO 2005/015149 A1 (Bussan Nanotech Research Institute Inc.), 17 February 2005 (17.02.2005), paragraphs [0065] to [0073], [0087]; fig. 10 | 1-9 |
| A | "User's Manual - Model SR844 RF Lock-in Amplifier - Revision 2.6 (10/2003)", [online], InternetArchive, 2006.03.16, [retrieval date 20 May 2010 (20.05.2010)], Internet <URL: http://web.archive.org/web/20060316151622/ http://www.thinksrs.com/downloads/PDFs/Manuals/ SR844m.pdf> pp.2-3 - 2-16 | 1-9 |

| ☒ Further documents are listed in the continuation of Box C. | ☒ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>20 May, 2010 (20.05.10) | Date of mailing of the international search report<br>01 June, 2010 (01.06.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
|---|
| PCT/JP2010/055619 |

C (Continuation).   DOCUMENTS CONSIDERED TO BE RELEVANT

| Category* | Citation of document, with indication, where appropriate, of the relevant passages | Relevant to claim No. |
|---|---|---|
| P,X | Toshiaki YAMAZAKI et al., "Relative phase detection by two modes simulations heterodyne detection", Extended Abstracts (The 56th Spring Meeting, 2009); The Japan Society of Applied Physics and Related Societies, no.3, 30 March 2009 (30.03.2009), page 1042 [1p-K-8] | 1-6 |
| A | JP 2005-069845 A  (Japan Science and Technology Agency), 17 March 2005 (17.03.2005), fig. 2; paragraph [0051] | 10-12 |

Form PCT/ISA/210 (continuation of second sheet) (July 2009)

| INTERNATIONAL SEARCH REPORT | International application No. |
|---|---|
| | PCT/JP2010/055619 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:


2. ☐ Claims Nos.:
   because they relate to parts of the international application that do not comply with the prescribed requirements to such an extent that no meaningful international search can be carried out, specifically:


3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
   (See extra sheet.)


1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:


4. ☐ No required additional search fees were timely paid by the applicant.   Consequently, this international search report is restricted to the invention first mentioned in the claims; it is covered by claims Nos.:


**Remark on Protest**          ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**EP 2 495 541 A1**

| **INTERNATIONAL SEARCH REPORT** | International application No. |
|---|---|
| | PCT/JP2010/055619 |

Continuation of Box No.III of continuation of first sheet(2)

Document 1: WO 2005/015149 A1 (Bussan Nanotech Research Institute, Inc.), 17 February 2005 (17.02.2005) cited in this international search report describes a device containing all of the matter that defines the invention in claim 1 of the present application.

Therefore, the invention in claim 1 is not novel over the invention described in document 1, and has no special technical feature.

As a result of the investigation of special technical features of claims dependent on claim 1, it has been revealed that in the claims of the present application, a plurality of inventions linked by respective special technical features, including invention 1 shown below, are contained.

Note that claim 1 which has no special technical feature, claims 2-3 which are constituted by merely the addition or conversion of well-known art onto claim 1 are classified into invention 1. Claims 4-6 merely have differences in category expression from claims 1-3, respectively, and thus they are also classified into invention 1.

(Invention 1) The inventions in claims 1-6
(Technical feature linked to invention 1) A relative phase detector for detecting, at high speed, the relative phases of two signals to be measured of different frequencies, using two reference signals, the relative phase detector being provided with:

a reference signal generation unit for generating the two reference signals which have a given frequency difference from the two signals to be measured, respectively;

a beat signal processing unit for generating, from the two signals to be measured and the two reference signals, a beat signal between the lower-frequency signal to be measured and the reference signal, and a beat signal between the higher-frequency signal to be measured and the reference signal, and generating a multiplication signal of the two beat signals; and

a relative phase detection unit for detecting the relative phases of the two signals to be measured by removing a constant defined by a detection system from a direct-current component of the multiplication signal.

Note that the linked technical feature is not a special technical feature, and thus claims 1-6 have no special technical feature.

Form PCT/ISA/210 (extra sheet) (July 2009)

**INTERNATIONAL SEARCH REPORT**
Information on patent family members

| International application No. |
|---|
| PCT/JP2010/055619 |

| WO 2005/015149 A1 | 2005.02.17 | CA 2511960 A1 | 2005.02.17 |
| | | CA 2511960 C | 2009.11.17 |
| | | EP 1655592 A1 | 2006.05.10 |
| | | EP 1655592 A4 | 2007.08.29 |
| | | JP 3820411 B2 | 2006.09.13 |
| | | US 2006/132793 A1 | 2006.06.22 |
| | | US 7426038 B2 | 2008.09.16 |
| JP 2005-069845 A | 2005.03.17 | (Family: none) | |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006293257 A

- JP 2001227911 A